# EUROPEAN PATENT APPLICATION

(11) **EP 0 818 764 A1**
(43) Date of publication of application: **14.01.1998**
(21) Application number: 97109442.0
(22) Date of filing: 11.06.1997
(51) Int. Cl.: G08B 5/22, H01L 27/15

(54) **Multi-functional portable electronic tranceiver**

(30) Priority: 21.06.1996 US 667792
(71) Applicant: MOTOROLA, INC., Schaumburg, IL 60196 (US)
(72) Inventor: Lebby, Michael S., Apache Junction, Arizona 85219 (US); Jachimowicz, Karen E., Laveen, Arizon 85339 (US); Jiang, Wenbin, Phoenix, Arizona 85044 (US)
(74) Representative: Gibson, Sarah Jane

(57) **Abstract**

A portable electronic transceiver (10) that has provided a miniature visual display (16), such as a miniature virtual image display, and/or a separate data interface and/or projection display port (22). The miniature virtual image display (16) utilizes an array of light emitting devices (42) as a light, or image, source (24). The data interface and/or projection display (17) utilizes a plurality of vertical cavity surface emitting lasers (VCSELs) (43) as a light source (24) and is capable of transmitting data through either a visible projection display (17), and/or a visible or infra-red data link. The light source (24) of the device (10) is composed of a single light emitting semiconductor chip (40) fabricated to emit light from an array of light emitting devices (LEDs) (42), one infra-red VCSEL (43) and/or a plurality of visible VCSELs (43).

## Description

### Field of the Invention

The present invention pertains, generally, to portable electronic transceivers and, more particularly, to a multi-functional portable electronic transceiver capable of receiving and transmitting communication data through multiple interfaces.

### Background of the Invention

Portable electronic transceivers, such as cellular and cordless telephones, pagers and the like, are becoming increasingly popular. In some instances it is possible to send complete messages, including alpha-numerics and/or graphics by way of novel devices. Thus, complete messages can be sent to specific recipients by way of a pager, or the like, and upon receiving the complete message, the recipient may wish to transmit a response. In these instances it is desirable to have an electronic transmitting device of some sort. In other instances it may be desirable to share with others the message received, and/or simply receive and/or transmit communication data to additional electronic devices. The problem is that it is difficult and unwieldy to carry various communication transceivers and electronic devices, e.g. telephones and/or two-way radios, as well as pagers, television remote controls and other devices.

In many instances it is desirable to provide a visual display on a communication transceiver to supply the operator with a visual message or graphical image. The problem is that the visual displays on prior art communications receivers are extremely limited in size, require relatively high electrical power as well as a great amount of area to be sufficiently large to produce a useful display, and in most instances are intended to be viewed by the operator of the device. In addition, and as previously stated, at times it is desirable for the image transmitted to the electronic transceiver to be viewable by more than just the user of the device. It is in this instance that a display capable of being viewed by many individuals is desired.

In the prior art, it is common to provide visual displays utilizing liquid crystal displays, directly viewed light emitting diodes, etc. These produce very large and cumbersome displays that greatly increase the size of the transceiver and require relatively large amounts of power. Further, such displays, when used on portable electronic devices, such as pagers, cellular telephones, or the like, greatly limit the amount of message that can be received.

In one instance, the prior art includes a scanning mirror to produce a visual display but again this requires relatively large amounts of power and is very complicated and sensitive to shock. Also, the scanning mirror causes vibration in the unit that substantially reduces visual comfort and acceptability.

Accordingly, a portable transceiver device that could receive communications and/or data, viewable through a visual display, such as a miniature virtual display, and receive and/or transmit data through a data interface port, such as an infra-red data interface and/or visible laser projection display would be highly advantageous.

It is a purpose of the present invention to provide a new and improved portable communication transceiver that includes a miniature visual display, such as a miniature virtual image display, and a laser projection display or free space data transmission link.

It is a further purpose of the present invention to provide a new and improved portable communication transceiver with miniature visual display and data transmission link and/or laser projection image display that substantially reduces the amount of power required for all components.

It is a still further purpose of the present invention to provide a new and improved portable communication transceiver with miniature visual display and projection display and/or data transmission link in which there is a dual light and/or image source formed on a single semiconductor chip, composed of surface LEDs and surface emitting lasers, such as vertical cavity surface emitting lasers (VCSELs).

### Summary of the Invention

The above problems and others are substantially solved and the above purposes and others are realized in a portable electronics transceiver that has provided a miniature visual display, such as a miniature virtual image display, and a separate data transmission link and/or projection image display. The miniature virtual image display utilizes an array of light emitting devices as an image or light source. The data transmission link and/or projection image display utilizes at least one vertical cavity surface emitting laser (VCSEL) as a light source and is capable of transmitting data through either a visible projection display, or data link, such as a free space data communications link. The light source of the device of the present invention is composed of a single light emitting semiconductor chip fabricated to emit light from an array of light emitting devices (LEDs), a single vertical cavity surface emitting laser (VCSEL), and/or a plurality of vertical cavity surface emitting lasers (VCSELs).

### Brief Description of the Drawings

The novel features believed characteristic of the invention are set forth in the claims. The invention itself, however, as well as other features and advantages thereof will be best understood by reference to detailed descriptions which follow, when read in conjunction with the accompanying drawings, wherein:
FIG. 1 is an isometric view of a television remote control/pager embodiment of the multi-functional transceiver device of the present invention;
FIG. 2 is a top view of a cellular telephone embodiment of the multi-functional transceiver device of the present invention;
FIG. 3 is a side view of the cellular telephone embodiment of the multi-functional transceiver device of the present invention;
FIG. 4 is an isometric view of a pager embodiment of the multi-functional transceiver device of the present invention;
FIG. 5 is a simplified cross-sectional view taken along line 5-5 of FIG. 1;
FIG. 6 is a simplified cross-sectional view taken along line 6-6 of FIG. 2;
FIGS. 7 - 10 illustrate various plan views of a partial semiconductor chip having formed thereon an array of LEDs and at least one VCSEL; and
FIG. 11 is a simplified diagram of the formation of a dual light source according to the present invention.

### Detailed Description of the Preferred Embodiment

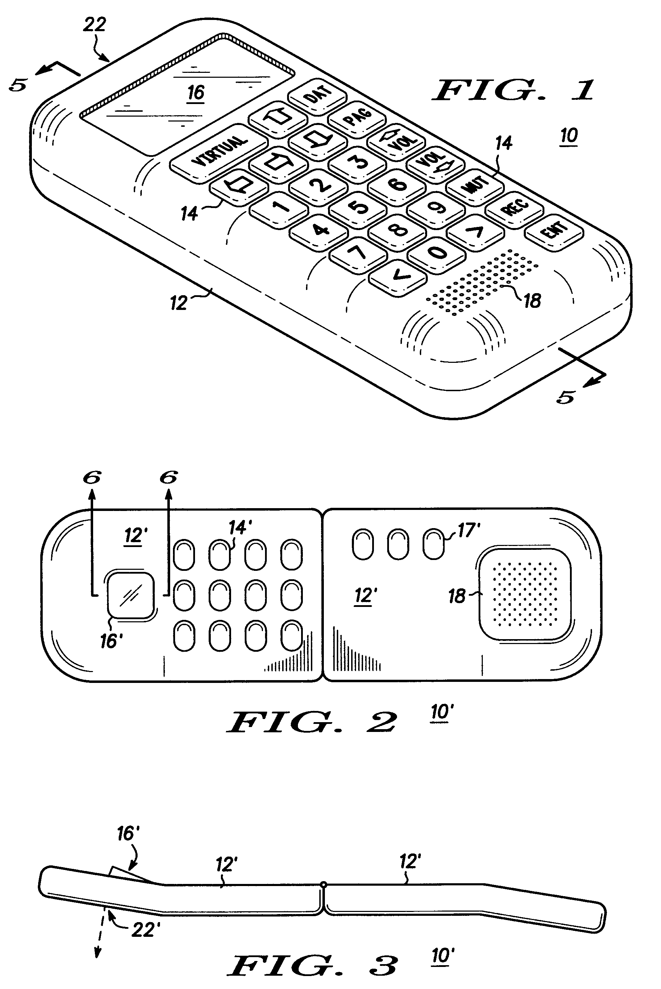

During the course of this description, like numbers are used to identify like elements according to the different figures that illustrate the invention. Disclosed is a portable electronics transceiver that has provided a miniature visual display, such as a miniature virtual image display, and a separate data interface port. The portable electronic transceiver can include any of the commonly known portable communication devices, such as pagers, cellular telephones, or two-way communication devices, as well as being composed of a combination of portable electronic devices. Turning now to the drawings, FIGS. 1 - 4 illustrate three specific structural embodiments of a portable electronic transceiver, referenced as 10, 10' and 10'', respectively, in accordance with the present invention. Referring to FIG. 1, illustrated is a portable electronic transceiver 10 fabricated in the form of a television remote control device, having included therein a data/communication transceiver (not shown). Portable electronic transceiver 10 includes a portable housing 12 which is ergonomically designed to be handheld, that is housing 12 is formed to conveniently fit the hand and allow comfortable use of a plurality of user interface controls 14 to operate transceiver 10.

Housing 12 includes a data/communication transceiver (not shown) constructed to receive data/communications through a data/communication input terminal and transmit data/communication through a data/communication output terminal utilizing either infrared or visible vertical cavity surface emitting lasers (VCSELs) and/or light emitting devices, such as inorganic or organic light emitting diodes, liquid crystal devices, lasers, etc. The data/communication transceiver is capable of receiving data/communications utilizing radio frequency signals, standard paging/cellular communication signals, well known in the art, or through infra-red signals received through the data interface port. In addition, there is mounted in housing 12 a visual display 16, such as a miniature virtual image display, mounted therein for providing a visual image of the data/communications received by transceiver 10 in the form of image data, such as alphanumeric and/or graphical messages. Visual display 16 utilizes an array of light emitting devices (discussed presently) as a light, or image source. There is also mounted in housing 12, a projection image display (not shown), for providing a projected image, emitted through the data interface port. The projection image display utilizes an array of vertical cavity surface emitting lasers (VCSELs) as a light or image source. Additionally, there is provided at least one vertical cavity surface emitting laser (VCSELs) as a light source capable of transmitting communication data through either an infra-red or visible laser data transmission link, such as a free space data communications link, emitted through the display port, dependent upon the user interface. Housing 12 contains a speaker 18 for receiving audible communications transmitted to portable electronic transceiver 10.

Electronics (not shown) are mounted in housing 12 in electrical communication with a circuit board, user interface controls 14 and the data/communication transceiver for receiving and/or transmitting data/communications. The circuit board containing the electronics is also positioned to have mounted thereon and electrically connected to the electronics the light source, including the two dimensional array of light emitting devices connected to provide a complete image in visual display 16 and the plurality of vertical cavity surface emitting lasers (VCSELs), to provide for the transmission link, or projection image display through the data interface port.

Referring now to FIGS. 2 and 3, illustrated in top and side view is an alternative embodiment of a portable electronic transceiver 10', incorporating cellular communications capabilities as well as a data communication interface. It should be noted that all components similar to the components illustrated in the first embodiment, as disclosed in FIG. 1, are designated with similar numbers, having a prime added to indicate the different embodiment. Portable electronic transceiver 10' includes a portable housing 12' which is ergonomically designed in the form of a cellular telephone and is meant to be handheld, that is housing 12' is formed to conveniently fit the hand and allow for comfortable use and operation of the device. Housing 12' is generally formed of two molded pieces, that when transceiver 10' is in an OFF or STANDBY mode, can be folded, one piece onto the other, to form a compact carrying case. Housing 12' includes a plurality of user interface controls 14' for controlling portable electronic transceiver 10'. It will of course be understood that the placement of user interface controls 14' is design specific, and those shown are representative of the design of this particular embodiment.

Housing 12' includes a data/communication transceiver (not shown) constructed to receive data/communications through a data input terminal and transmit data/communications through a data/communication output terminal utilizing either infra-red or visible vertical cavity surface emitting lasers (VCSELs) and/or light emitting devices, such as inorganic or organic light emitting diodes, liquid crystal devices, lasers, etc. In addition, there is mounted in housing 12' a visual display 16', including a data input terminal, mounted therein for providing a visual image of the data/communication received by portable electronic transceiver 10' and a projection image display (not shown), including a data input terminal for providing a visual image of the data/communication received by transceiver 10'. Additionally, housing 12' contains a speaker 18' and a microphone 20 for receiving and transmitting audible informational data to and from portable electronic transceiver 10'. Electronics (not shown) are mounted in housing 12' in electrical communication with visual display 16', a circuit board (not shown), user interface controls 14', the data/communication transceiver (not shown), the projection image display (not shown), and a data interface port 22' for transmitting/emitting data through the use of either visible VCSELs, used in the projection image display, or visible or infrared VCSELs, for use in transmitting data to a computer, printer, television, fax machine, or the like. The circuit board containing the electronics is also positioned to have mounted thereon and electrically connected to the electronics, a light generation apparatus, including a dual light source or light emitting chip (discussed presently), composed of a two dimensional array of light emitting devices (LEDs) connected to provide a complete image in visual display 16' and a plurality of vertical cavity surface emitting laser (VCSEL), connected to provide for the data link utilizing infra-red or visible VCSELs or the projection display utilizing visible VCSELs.

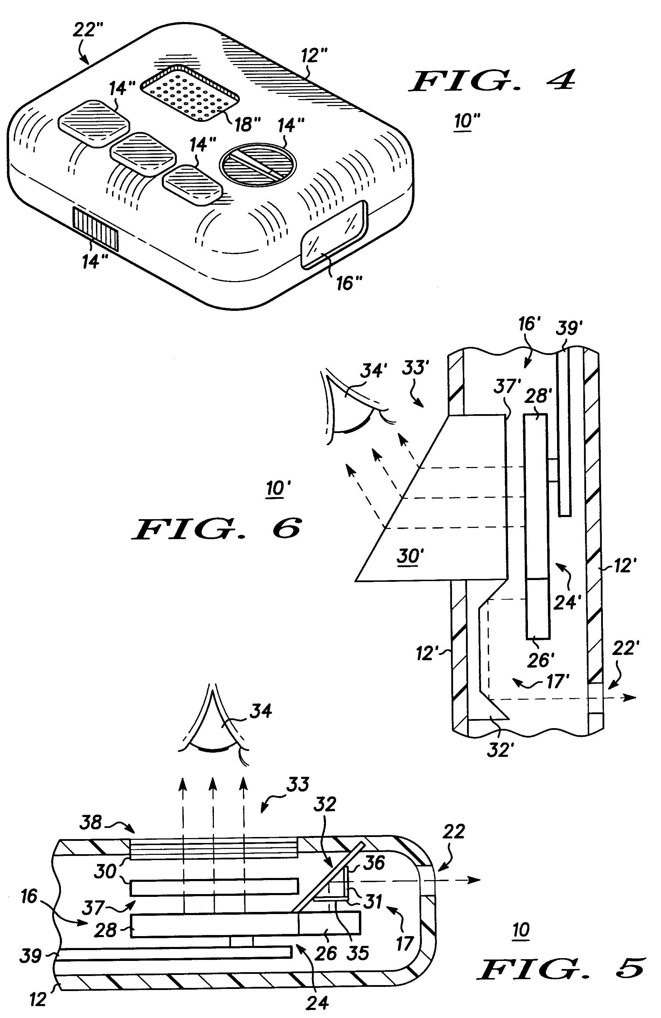

Referring now to FIG. 4, illustrated is another alternative embodiment of a portable electronic transceiver 10'', incorporating paging communication capabilities. It should be noted that all components similar to the components illustrated in FIGS. 1 and 2, are designated with similar numbers, having a double prime added to indicate the different embodiment. Portable electronic transceiver 10'' includes a portable housing 12'' which is ergonomically designed in the form of a common paging device and is meant to be handheld, that is housing 12'' is formed to conveniently fit the hand and allow for comfortable use and operation of the device. Housing 12'' includes a plurality of user interface controls 14'' for controlling portable electronic transceiver 10''. It will of course be understood that the placement of user interface controls 14'' is design specific, and those shown are representative of the design of this particular embodiment of portable electronic transceiver 10''. It is disclosed that interface controls 14'', in particular those controlling the focusing of visual display 16'', can be mechanical or electrical in operation.

Housing 12'' has a visual display 16'', including a data input terminal, mounted therein and a projection display (not shown) for providing a virtual and/or projected visual image of the data received by portable electronic transceiver 10''. Additionally, housing 12' contains a speaker 18'' for receiving audible informational data transmitted to portable electronic transceiver 10''. Electronics (not shown) are mounted in housing 12'' in electrical communication with a circuit board, user interface controls 14'', a data/communication transceiver, and a data interface port 22'' for transmitting data. The circuit board containing the electronics is positioned to have mounted thereon and electrically connected to the electronics a light source, including a two dimensional array of light emitting devices connected to provide a complete image in visual display 16'' and at least one vertical cavity surface emitting laser (VCSEL), to provide for an infra-red or visible laser data transmission link or a projection image display.

It should be understood that the various embodiments of portable electronic transceiver 10, 10', and 10'' of the present invention can contain any combination of receiving and/or transmitting capabilities and or device configurations, and is not meant to be limited to those specific embodiments disclosed above. In all embodiments, generally, the electronics include a central processing unit (CPU) and memory (RAM or ROM) capable of working with the light source (discussed presently), visual display 16, the projection display, the data transmission link and data interface port 22.

Referring now to FIGS. 5 and 6, illustrated in simplified cross-sectional views, FIG. 5 taken along line 5-5 of FIG. 1 and FIG. 6 taken along line 6-6 of FIG. 2, is the relation between the light source of the present invention and the structure of portable electronic transceiver 10, the television remote control/pager embodiment and portable electronic transceiver 10', the cellular telephone embodiment. More specifically, illustrated in FIG. 5 in simplified cross-sectional view is portable electronic transceiver 10, according to the previous description. Portable electronic transceiver 10 has mounted within housing 12, visual display 16, a projection image display 17, electronics 39, and a light generating apparatus 24 generally composed of the light source, a plurality of optical elements, and driver circuits. The light source contained within light generating apparatus 24 of the device of the present invention is composed of a semiconductor chip having formed thereon an array of light emitting devices (LEDs) and at least one vertical cavity surface emitting laser (VCSEL). It should be understood that the light emitting devices (LEDs) utilized for visual display 16, include a wide variety of light emitting devices, including liquid crystal displays (LCDs), light emitting diodes (LEDs), both organic and inorganic, and vertical cavity surface emitting lasers (VCSELs), etc., but the term light emitting devices will be utilized throughout this description for simplicity.

Transceiver 10 is capable of operation in a dual mode with regard to the VCSEL(s) light source dependent upon the fabrication and the wavelength of the light emitted. More specifically, a first mode of operation is utilized for the generation of a projection display generated by a full array of visible VCSELs or a reduced number of visible VCSELs that are scanned to generate a display and a second mode of operation is utilized for the generation of a data transmission link generated by at least one infra-red or visible VCSEL.

Light generating apparatus 24, as illustrated in FIGS. 5 and 6, is composed of two separate emitting regions, more specifically a first LED region 28 and a second VCSEL region 26. LED region 28 of the semiconductor chip of apparatus 24 has formed thereon an array of LEDs. VCSEL region 26 of the semiconductor chip of apparatus 24 has formed thereon an array of visible VCSELs for generation of a projection display, and/or at least one VCSEL for generation of a data transmission link, dependent upon the mode of operation. It should be understood that although VCSEL region 26 and LED region 28 are shown as being separate regions, alternate array layouts are disclosed below in which the two regions 26 and 28 are more closely related, as well as LED region 28 and VCSEL region 26 being fabricated on opposed surfaces of the semiconductor chip (discussed presently).

During operation, light emitted by the array of LEDs formed in LED region 28 of the semiconductor chip, passes through an optical magnification system, schematically illustrated here as composed of optical elements 30, thereby generating a complete image, viewable by an eye 34 of an observer. More specifically, optical elements 30 include a light inlet 37 and a light outlet 38, optically positioned so as to direct light from light inlet 37 to light outlet 38. Optical elements 30 include at least one aspheric surface (not shown) for aberration correction, and define a light path from light inlet 37 to light outlet 38 with a total average optical length in a range of approximately 25 to 35 millimeters. There is at least one diffractive optical element (not shown) positioned in the light path so as to provide further aberration correction. The plurality of optical elements 30 are constructed to magnify the image at light inlet 37 of the first optical element. During operation in a data transmission mode, infra-red or visible light emitted by VCSEL region 26, is reflected by a reflective optical module, or element, 32. Accordingly, the infra-red or visible light is emitted from VCSEL region 26 of apparatus 24 and reflected so as to emit through data interface port 22. When operating to generate a projection image, visible VCSELs emitted by VCSEL region 26 generate light which is reflected and magnified by projection image display 17, generally composed of a reflective optical element 32 and additional optical elements 31 if required, thereby directing the light through data interface port 22 and thus generating the projected image. The projection image display 17 includes a data input terminal (not shown)designed to receive image data thereon. As stated, there may be provided a plurality of optical elements 31 having a light inlet 35 and a light outlet 36 directed at an angle to light inlet 35, with a reflecting surface, such as that of reflective optical element 32, optically positioned between light inlet 35 and light outlet 36 so as to direct light from light inlet 35 to light outlet 36. The plurality of optical elements include at least one aspheric surface for aberration correction. The plurality of optical elements 31 define a light path from light inlet 35 to light outlet 36. There is provided at least one diffractive optical element (not shown) positioned in the light path so as to provide further aberration correction.

Referring now to FIG. 6, illustrated in simplified cross-sectional view taken along line 6-6 of FIG. 2 is the relation between the light source and the structure of portable electronic transceiver 10', the cellular telephone embodiment. Illustrated in FIG. 6 is portable electronic transceiver 10', according to the previous description. Portable electronic transceiver 10' has mounted within housing 12', a light generating apparatus 24', generally similar to apparatus 24 described above and electronics 39'. The light source contained within light generating apparatus 24' of the device of the present invention is similarly composed of a semiconductor chip (not shown) having formed thereon an array of light emitting devices (LEDs) and at least one VCSEL. It should be understood that in the event visible VCSELs are utilized to generate a projection image, a full array of visible VCSELs or a reduced number of visible VCSELs, that are scanned to form a projected image, are formed on the semiconductor chip.

Light generating apparatus 24', or image generating apparatus, with the array of light emitting devices and at least one VCSEL, formed as a part thereof is generally composed of a VCSEL region 26' and a LED region 28' as previously described with regard to FIG. 6.

As illustrated in FIGS. 5 and 6, VCSEL region 26 and light emitting device region 28 are formed side-by-side on one surface of a substrate, thereby minimizing cost of manufacture. It should be understood that VCSEL region 26 and light emitting device region 28 can be formed on one surface, or side, of a single substrate, as previously illustrated and described, or alternatively formed on opposed surfaces, or sides, of a single substrate (discussed presently) sharing the same substrate member. During the fabrication of apparatus 24, generally the semiconductor chip is mounted on the under-surface of a glass substrate and a driver board is bump-bonded to the substrate. Additional information on driver boards and bonding of substrates to the driver boards is disclosed in United States Patent No. 5,432,358, entitled "Integrated Electro-optical Package", issued July 11, 1995 and assigned to the same assignee, which information is included herein by reference. During operation of the transceiver of the present invention, each light emitting device is turned ON with approximately 1.8 volts and utilizes approximately 50µA of current when it is turned ON and each VCSEL is turned on with approximately 1.5-2.5 volts and utilizes approximately 2-5 mA of current when turned on.

As described above, visual display 16' further includes, an optical magnifier, generally composed of optical elements 30', defining a light path from the LED region 28' of apparatus 24' to a viewing aperture 33' of visual display 16', through which the generated image is viewable by the eye 34' of an observer. The plurality of optical elements 30' are constructed to magnify the complete image, generated by LED region 28' of apparatus 24', at a light inlet of a first optical element 30'. Because of the length of the optical path and the size of apparatus 24', the horizontal field of view of the optics ranges from approximately 11 degrees at a magnification of 10x to 22 degrees at a magnification of 20x, with the present embodiment having a horizontal field of view of approximately 16 degrees and a magnification of 15x. There is further provided a projection image display 17', generally composed of a reflective optical element 32', and additional optical elements (not shown) dependent upon the mode of operation of the transceiver 10', positioned in optical alignment with VCSEL region 26', so as to receive the light generated by the VCSEL(s) and reflect and project it out of the viewing path through data interface port 22'. It should be understood that when operating in a data transmission mode, at least one LED or VCSEL can be utilized as the free-space optical communication source, although VCSELs have been found to be faster, thus more efficient than LEDs, which aids in data transmission link applications. It should be understood that when operating in a projection display mode, a full array of VCSELs, or smaller array of VCSELs in conjunction with a scanner, is utilized, thus a larger power/battery source than that required by the LED array, may be necessary, depending upon the efficiency of the lasers.

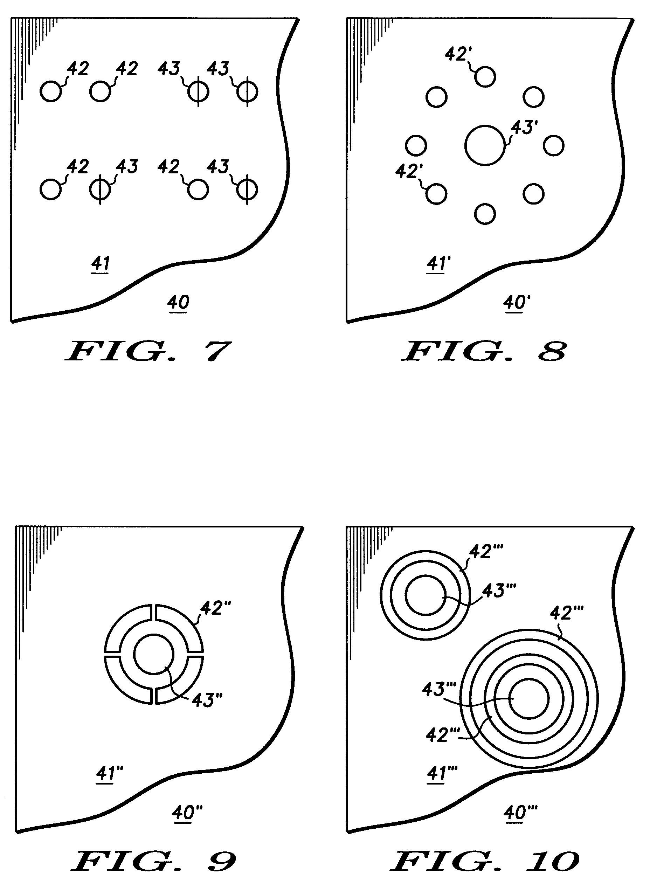

As previously described, the semiconductor chip of apparatus 24, is fabricated to emit light from both an array of LEDs and at least one VCSEL formed on a semiconductor chip. Referring now to FIGS. 7-10, disclosed are a plurality of array layouts of a semiconductor chip according to the present invention. More specifically, illustrated in each of the FIGS. 7-10 is a partial semiconductor chip 40, 40', 40'', and 40''', respectively, having formed thereon the light emitting sources of apparatus 24. More specifically, illustrated in FIG. 7 is partial semiconductor chip 40 having formed thereon a major surface 41, a plurality of LEDs 42 and a plurality of VCSELs 43. Two formations are illustrated, the first having a plurality of LEDs 42 formed side-by-side, and a plurality of VCSELs 43 formed side-by-side, generally similar to the formation of LED region 28 and VCSEL region 26, previously described with reference to FIGS. 5 and 6. Alternatively, illustrated is the alternating alignment of LEDs 42 and VCSELs 43, yet still in a side-by-side formation.

Referring now to FIG. 8, illustrated is partial semiconductor chip 40' having formed thereon a major surface 41', a single VCSEL 43' surrounded by a plurality of LEDs 42'. Alternatively, dependent upon the mode of operation of transceiver 10 of the present invention, partial semiconductor chip 40' is formed having a single LED 42' formed thereon major surface 41', surrounded by a plurality of VCSELs 43'.

Referring now to FIG. 9, illustrated is a partial semiconductor chip 40'' having formed thereon a major surface 41'', a single VCSEL 43'', surrounded by a plurality of segmented LEDs 42''. Similarly illustrated in FIG. 10 is a partial semiconductor chip 40''' having formed thereon a major surface 41''', two variations of a single VCSEL 43''', surrounded by a single ring of LEDs 42''' or a double ring of LEDs 42'''. It should be understood that the various disclosed array layouts are fabricated according to the design and intended use of transceiver 10 of the present invention.

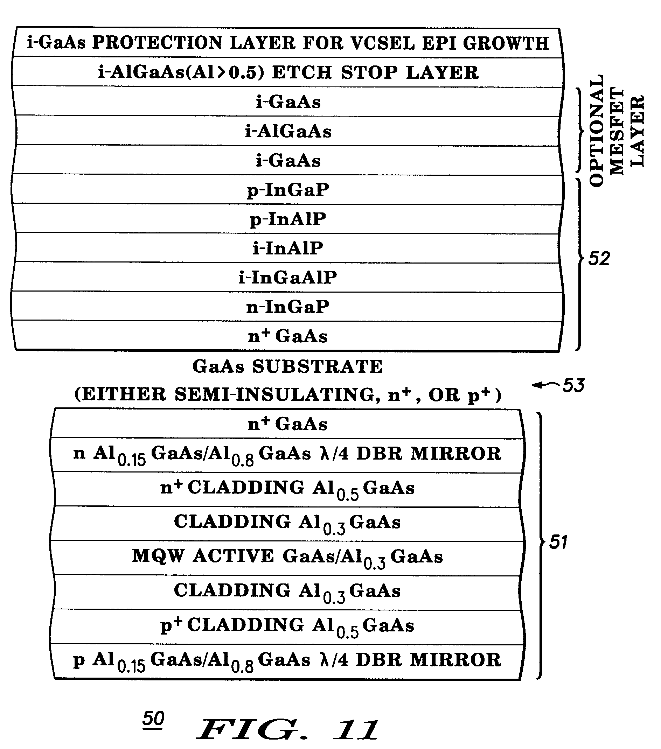

As stated previously, the array of LEDs 42 and the at least one VCSEL 43 can be fabricated on the same major surface or alternatively opposed major surfaces of a single substrate utilizing standard epitaxial layer growth techniques. Referring now to FIG. 11, illustrated is a diagram of the formation of a partial display device 50, diagramming the layers of materials utilized in the formation of a standard visible LED 51 (generally similar to LED 42, previously described) and VCSEL 52 (generally similar to VCSEL 43, previously described) on opposed surfaces, or sides, of a single substrate 53. Standard epitaxial deposition of multiple alternate layers of different compositions are utilized to form the LEDs 51 and VCSELs 52 of the present invention, and accomplished by well known techniques in the art such as MBE, MOCVD, or the like. These techniques enable epitaxial deposition of relatively thin and thick layers of a variety of materials such as gallium arsenide (GaAs), aluminum gallium arsenide (AlGaAs), aluminum arsenide (AlAs), indium phosphide (InP), indium aluminum gallium phosphide (InAlGaP), or the like. The key in the process of forming the light source to emit from opposed surfaces, or sides, of the substrate is to protect the epitaxial structure on the underneath side of the wafer from scratches and unnecessary etching. It is proposed to utilize a thick layer of gallium arsenide (GaAs) to allow for typical processing scratches and markings. The LED array is fabricated using standard implant techniques, etching techniques, or a combination of both. Further detailed information regarding the fabrication of the array of LEDs can be found in U.S. Patent No. 5,453,386, entitled "METHOD OF FABRICATION OF IMPLANTED LED ARRAY", issued September 26, 1995, and U.S. Patent No. 5, 449,926, entitled "HIGH DENSITY LED ARRAYS WITH SEMICONDUCTOR INTERCONNECTS", issued September 12, 1995, both assigned to the same assigned, and incorporated herein by this reference. Further detailed information regarding the fabrication of vertical cavity surface emitting lasers (VCSELs) can be found in U.S. Patent No. 5, 258,316, entitled "PATTERNED MIRROR VERTICAL CAVITY SURFACE EMITTING LASER", issued November 2, 1993, and U.S. Patent No. 5, 293,392, entitled "TOP EMITTING VCSEL WITH ETCH STOP LAYER", issued March 8, 1994, both assigned to the same assignee and incorporated herein by this reference.

Thus, disclosed is a transceiver device which incorporates a visual display, such as a miniature virtual image display, generated by a plurality of light emitting devices, a projection display generated by a plurality of visible VCSELs, and/or a data transmission link, generated by at least one infra-red or visible VCSEL. A light source is fabricated as a single semiconductor chip, having formed thereon the plurality of light emitting devices and the at least one VCSEL. Disclosed are a plurality of array formations of the LEDs and at least one VCSEL fabricated on a single surface of the semiconductor chip. The semiconductor chip is further disclosed as alternatively fabricated to have the array of LEDs and the at least one VCSEL formed on opposed surfaces of the substrate, utilizing dual-sided epitaxial layer growth, thereby capable of emitting light in opposed directions.

While we have shown and described specific embodiments of the present invention, further modifications and improvement will occur to those skilled in the art. We desire it to be understood, therefore, that this invention is not limited to the particular forms shown and we intend in the appended claims to cover all modifications that do not depart from the spirit and scope of this invention.

## Claims

1. A portable electronic transceiver characterized by:
a portable housing (12) including a viewing aperture (33) and a data interface port (22);
a data/communication transceiver mounted in the portable housing (12) and constructed to receive and transmit data/communications through a data/communication input terminal and a data/communication output terminal;
a light generation apparatus (24) including a dual light source, comprised of a single semiconductor chip (40) having formed thereon an array of light emitting devices (42) and at least one vertical cavity surface emitting lasers (VCSELs) (43); and
electronics (39) mounted in the portable housing (12) and connected to an output terminal of the data/communication transceiver for transmitting and receiving data/communications and further connected to the light generation apparatus (24) for supplying image data in response to received data/communications.

2. A portable electronic transceiver as claimed in claim 1 further characterized in that the array of light emitting devices (42) is formed in a two dimensional array.

3. A portable electronic transceiver as claimed in claim 2 further characterized in that the two dimensional array of light emitting devices (42) includes light emitting diodes.

4. A portable electronic transceiver as claimed in claim 2 further characterized in that the two dimensional array of light emitting devices (42) includes liquid crystal devices.

5. A portable electronic transceiver as claimed in claim 2 further characterized in that the two dimensional array of light emitting devices (42) includes vertical cavity surface emitting lasers (VCSELs) (43).

6. A portable electronic transceiver as claimed in claim 2 further characterized in that the at least one vertical cavity surface emitting laser (VCSEL) (43) includes an array of visible vertical cavity surface emitting lasers (VCSELs).

7. A portable electronic transceiver as claimed in claim 2 further characterized in that the at least one vertical cavity surface emitting laser (43) includes at least one of an infra-red vertical cavity surface emitting laser (VCSEL) and a visible vertical cavity surface emitting laser (VCSEL).

8. A portable electronic transceiver as claimed in claim 2 further characterized in that the array of light emitting devices (42) and the at least one vertical cavity surface emitting laser (43) (VCSEL) are formed on one surface (41) of the single semiconductor chip (40).

9. A portable electronic transceiver as claimed in claim 2 further characterized in that the array of light emitting devices (42) and the at least one vertical cavity surface emitting laser (VCSEL) (43) are formed on opposed surfaces of the single semiconductor chip (40), thereby sharing a single substrate element (53) and emitting light in opposed directions.

10. Light generation apparatus characterized by a dual light source (24), including a single semiconductor chip (40) having formed thereon an array of light emitting devices (42) and at least one vertical cavity surface emitting laser (VCSEL) (43).
